# EUROPEAN PATENT SPECIFICATION

(11) **EP 0 540 692 B1**
(45) Date of publication and mention of the grant of the patent: **26.04.1995**
(21) Application number: 91915860.0
(22) Date of filing: 18.07.1991
(51) Int. Cl.: G01R 33/06

(54) **MINIATURE HIGH-SENSITIVITY MAGNETORESISTIVE MAGNETOMETER**
MINIATUR HOCH-SENSITIVER MAGNETORESISTIVER MAGNETOMETER
MAGNETOMETRE MINIATURE DU TYPE MAGNETO-RESISTIF ET A HAUTE SENSIBILITE

(30) Priority: 26.07.1990 US 558352
(43) Date of publication of application: 12.05.1993
(73) Proprietor: EASTMAN KODAK COMPANY, Rochester, New York 14650-2201 (US)
(72) Inventor: SMITH, Neil, San Diego, CA 92117 (US); JEFFERS, Frederick, John, Escondido, CA 92025 (US)
(74) Representative: Lewandowsky, Klaus, Dipl.-Ing.
(86) International application number: US9105036
(87) International publication number: WO9201945

(56) References cited:
- EP-A- 0 064 786
- US-A- 4 455 626
- US-A- 4 679 107
- US-A- 4 803 581

## Description

### BACKGROUND OF THE INVENTION

### 1. Technical Field of the Invention

This invention relates to a sensor for measurement of magnetic fields, and in particular to a magnetic field sensor using a magnetoresistive (MR) element and associated flux collectors.

### 2. Description Relative to the Background Art

A wide variety of sensors are known in the art for use in measuring magnetic fields. Among these are the Hall effect sensor, proton resonance effect sensor, superconducting quantum interference detector (SQUID), fluxgate magnetometer, inductive pickup, magnetoresistive sensor and others. Depending upon the application, one or another of the above sensors may be chosen for a particular magnetic field measurement.

Among these sensors, the MR sensor has proven to be one the most versatile magnetic field detectors. The single strip MR conventional element is relatively simple to fabricate, has a flat frequency response to very high frequencies, and has acceptable sensitivity, i.e. signal voltage per unit signal field, for typical field measurements. For low amplitude magnetic field measurements, however, the sensitivity of an MR sensor of such a single strip configuration is limited. Large area MR sensors have been developed where the MR element is deposited on a substrate in a meandering pattern, increasing the length of the MR element many fold compared to a conventional single strip MR. This configuration increases the total resistance of the sensor, and as the signal is proportional to the change of resistance with applied magnetic field, the sensitivity of the sensor is correspondingly improved. However, as the sensitivity is proportional to the square root of the power, the power dissipation increases more rapidly than does the sensitivity with increasing resistance. Additionally, the large area sensor takes up a relatively large volume due to the increased surface occupied by the MR element, precluding the possibility of its use as a small probe for measuring the magnetic field in a localized space. Such a large area sensor is described by Kwiatkowski and Tumanski, "Journal of Physics E: Scientific Instruments", Great Britain, Volume 19, 1986, page 510.

It is known in the prior art that the sensitivity of an MR sensor may be improved by providing high permeability flux collectors in line with the MR element. The prior art teaches the use of bulk permalloy rod flux collectors with dual MR sensors such that the overall length of the sensor assembly is approximately 20 centimeters. (O.Gebhardt, W. Richter, "Experimentelle Technik der Physik", Volume 39, 1982, pages 363- 367.) It will be appreciated that as with the large area sensor, the dual MR sensor with bulk permalloy rod flux collectors, being 20 centimeters in length, is unsuitable as a probe for field measurement in restricted volumes.

In the prior art, thin layer magnetic sensors are also known for measurement of the amplitudes of magnetic fields. For example, the European Patent Application 0 064 786 describes a magnetic sensor having a magnetoresistive element which bridges a gap between two flux conductors. To the high sensitivity of the sensor, the interaction of the magnetoresistive element with the flux conductors is very important which is defined by the thin layer arrangement, the shape and distance of the gap.

To obtain a satisfactory interaction, however, it is disadvantageous if the magnetoresistive element is overlapped by the magnetic flux conductors laterally and in a thin layer plane offset from the magnetoresistive element surface and is additionally separated by a quartz layer as described in EP 0 064 786.

The US-PS 4,803,581, too, describes a thin film magnetic head for detecting signals recorded on a magnetic medium by use of a magnetoresistive element which is simplified in structure so as to yield a high reproducing output.

The arrangement of the magnetic layer in connection with the dimension of the gap does not allow the measured amplitudes of the magnetic fields to be as low as 10⁻⁶ oersted. An essential reason is that the lamination of the high permeable magnetic material dos not exist to avoid eddy current losses at high frequencies.

### DISCLOSURE OF INVENTION

A miniature sensor, in accordance with the invention, is suitable for measuring uniform magnetic fields and includes a substrate, a planar magnetoresistive element, and first and second electrical conductors deposited on a major surface of said substrate and connected, respectively, to opposing ends of the magnetoresistive element for applying a sense current therethrough. In particular, the magnetoresistive element has a "height" dimension h between lateral edges connecting the opposing ends of the magnetoresistive element, and first and second laminated flux collectors of respective "heights" H₁ and H₂, deposited on the major surface of the substrate, the first layer of said first and second laminated flux collectors partially overlapping the surface of said magnetoresistive element in substantially co-planar relationship therewith wherein the first and second laminated flux collectors are separated laterally by a gap G which is less than the "height" h of the magnetoresistive element. The miniature sensor has a resultant "height" of H₁+H₂+G, with the dimensionless ratio (H₁+H₂+G)/G being greater than about 50.

The flux collectors increase the sensitivity of the sensor of the invention to equal or exceed the sensitivity of dual strip MR sensor with flux collectors known in the prior art. The thin film sensor of the invention is capable of responding to fields of amplitude as low as 10⁻⁶ oersted with a measurement bandwidth of 3 Khz, and exhibits uniform response from d.c. to well above 1 Mhz. The flux collectors comprise laminations of deposited high permeability magnetic material to avoid eddy current losses at the high frequencies. An even number of laminations in each flux collector enhances magnetic coupling between the two laminations comprising each pair, minimizing Barkhausen noise due to domain formation in the laminations.

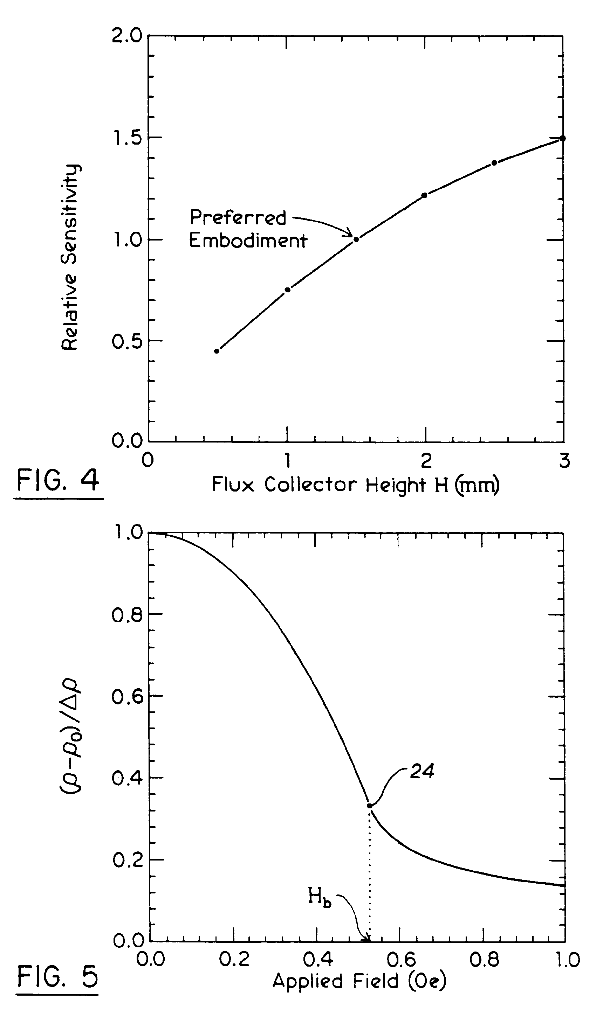

A coil may be wound over the sensor and substrate as a means to apply either a.c. or d.c. bias, H_{b}, (Fig. 5) for linearizing the output of the sensor, or for compensation of unwanted static or low frequency interfering magnetic fields. The substrate mounted sensor and flux collectors, and the coil may be packaged in a volume smaller than 1 cubic centimeter.

The MR element of the sensor is shaped as a rhomboid, as taught in U.S. Patent No. 4,956,736. The rhombic shape of the MR element helps prevent the formation of multiple domains in the MR element with attendant Barkhausen noise after recovery from an overload signal which may temporarily saturate the MR element.

The dimensions of the MR element and flux collectors have been optimized for maximum sensitivity and for miniaturization of the sensor. The thin film deposition techniques utilized in fabrication of the sensor allow overlapping the flux collectors and the MR element, and the sizing of the thickness and gap spacing of the flux collectors so that maximum sensitivity is attained in a simple, compact and economical manner.

### BRIEF DESCRIPTION OF DRAWINGS

Fig. 1a is a drawing of the magnetic field sensor of the invention;
Fig. 1b is an expanded view of the laminated construction of the flux collector seen in Fig.1a;
Fig. 2 is a plot of the relative sensitivity of the sensor of invention as a function of the MR element height;
Fig. 3 is a plot of the relative sensitivity of the sensor of the invention as a function of the flux collector thickness;
Fig. 4 is a plot of the relative sensitivity of the sensor of the invention as a function of the flux collector height;
Fig. 5 is a normalized response curve of the magnetoresistive dependent resistance change of the sensor of the invention as a function of applied magnetic field; and
Fig. 6 is a drawing of the sensor of the invention including a compensation coil.

### BEST MODE FOR CARRYING OUT THE INVENTION

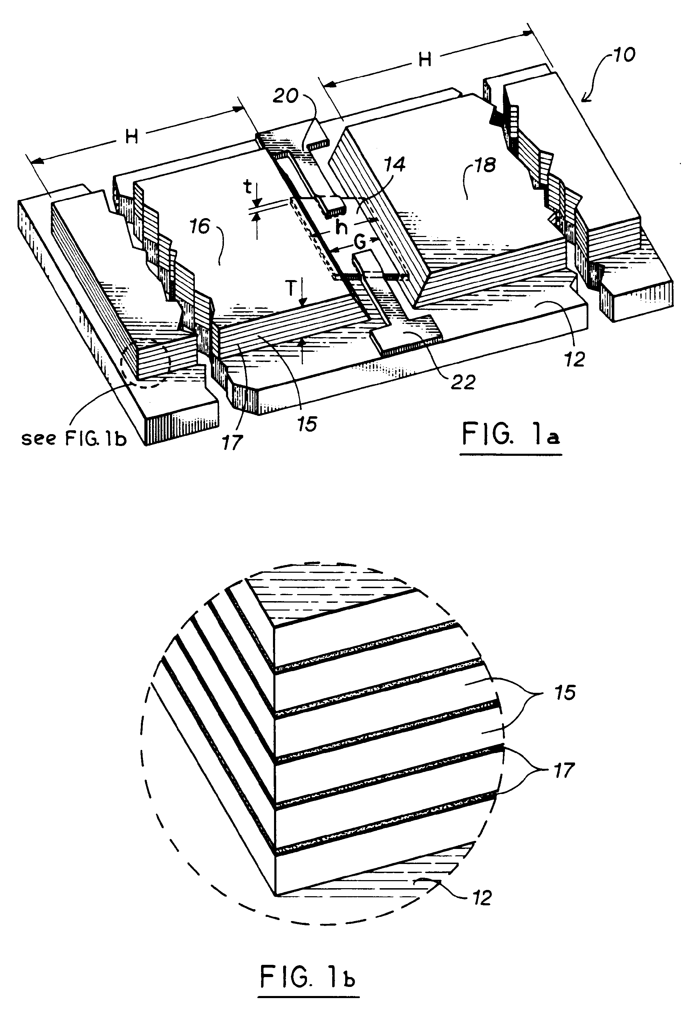

Referring to Fig. 1a, a preferred embodiment of the magnetic field sensor 10 comprises a substrate 12 upon which is deposited a permalloy MR element 14. Conductors 20,22, which serve for conducting sense current through the MR element 14, are deposited in electrical contact with the MR element 14. A thin layer of SiO₂ is deposited to insulate the MR element 14 from flux collectors 16,18 which are then deposited contiguous to, and slightly overlapping the edges of the MR element 14. Each flux collector 16,18 comprises six stacked 1-micron thick laminations 15, of highly permeable NiFe magnetic material separated by 0.1 micron layers of SiO₂ 17, as seen in Fig. 1a and Fig. 1b.

The voltage drop across the MR element 14 due to the flow of sense current via the conductors 20, 22, varies in accordance with the resistance change of the MR element 14 resulting from a changing magnetic field applied to the element 14 by means of the flux collectors 16,18.

In the miniature preferred embodiment the thickness, t, of the MR element 14 was 250 angstroms, and the MR element 14 had a rhomboid shape of interior angle 30 degrees, to provide protection against domain formation as described above. The anisotropy field was 4 oersted, which is readily attainable using conventional magnetic material thin film deposition techniques. The magnetic permeability of the MR element 14 and the flux collectors 16,18 was approximately 2000.

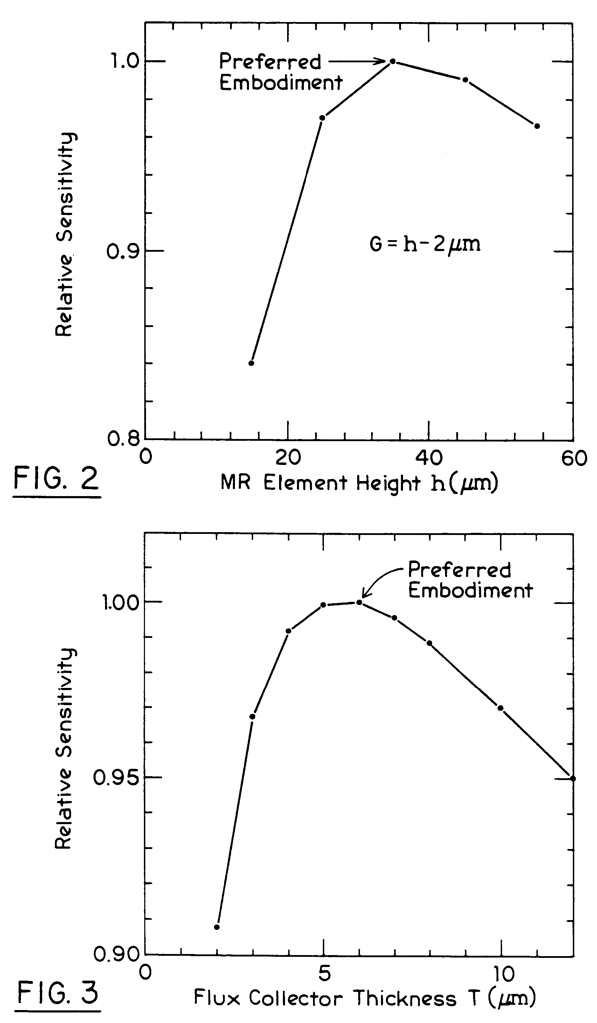

Optimization of the height of the MR element to obtain maximum sensor sensitivity may be understood by reference to the graph of Fig. 2. The data represented in Fig. 2, is based on a constant overlap of 1 micron between the element 14 and the flux collectors 16,18 as seen in Fig. 1a. This overlap insures close coupling of the MR element 14 to the flux collectors 16,18. As seen in Fig. 2, at low MR element heights, h, the relative sensitivity of the element increases with height because as the height increases, the shape anisotropy which limits the net permeability of the MR element decreases. After a peak in sensitivity at a height of 35 microns, the relative response begins to decrease with a continuing increase of the height, h. This occurs because the efficiency of the flux coupling starts to fall off as the reluctance of the gap G between the flux collectors increases as the height grows, (for a constant 1 micron overlap). The height of the MR element in the preferred embodiment was accordingly set at the response peak, that is, at 35 microns.

Referring to Fig. 3, a similar peak occurs for the thickness T of the flux collectors, and for optimized performance the overall thickness of the flux collectors was set at approximately 6 microns in the preferred embodiment.

It may be seen from Fig. 4 that the sensitivity of the sensor increases directly with the height H of the flux collectors. With the goal of packaging the entire sensor in less than 1 cubic centimeter while maintaining adequate sensitivity, the flux collector 16,18 height H was set at 1500 microns in the preferred embodiment.

Referring to Fig. 5, it will be appreciated that the sensor of the present invention has about ten times the sensitivity in response to an applied magnetic field as do other single film sensors of the prior art. In particular, when operated about the normal bias point i.e. the point of inflection, 24, of the curve of Fig. 5, and with a suitable amplifier, the sensor of the invention is capable of detecting low level magnetic fields of amplitude 10⁻⁶ oersted over a frequency range from d.c. to at least 1 Mhz, with a bandwidth of 3 Khz.

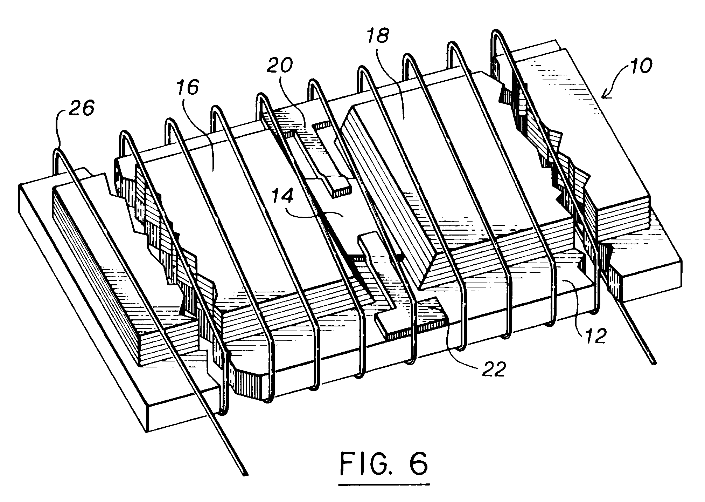

It will be appreciated that having such a high sensitivity, the sensor may readily be saturated by the earth's magnetic field during normal use. Referring to Fig. 6, provision is made to wrap the entire sensor with a low frequency excitable compensation coil 26 to allow generating a compensation field to buck any unwanted low frequency field. The compensation field may simultaneously contain a d.c.component to provide a bias field, Hb (Fig.5) to the element 14.

## Claims

1. A sensor (10) of the type suitable for measuring uniform magnetic fields, said sensor including a substrate (12), a planar magnetoresistive element (14), and first and second electrical conductors (20, 22) deposited on a major surface of said substrate and connected, respectively, to opposing ends of said magnetoresistive element for applying a sense current therethrough,
**characterized in that**
said magnetoresistive element (14) has a "height" dimension h between lateral edges connecting said opposing ends of said magnetoresistive element;
in that first and second laminated flux collectors (16, 18) of respective "heights" H₁ and H₂, are deposited on said major surface of said substrate, a first layer of said first and second laminated flux collectors (16, 18) partially overlapping the surface of said magnetoresistive element (14) in co-planar relationship therewith, in that said first and said second laminated flux collectors are separated laterally by a gap G which is less than the "height" h of said magnetoresistive element, and in that said magnetic field sensor has a resultant "height" of H₁+H₂+G, with the dimensionless ratio (H₁+H₂+G)/G being more than 50.

2. A magnetic field sensor as defined in claim 1 wherein the "heights" of said first and second laminated flux collectors (16, 18) are substantially equal.

3. A magnetic field sensor as defined in claim 1 wherein the sensitivity of said magnetic field sensor (10) increases as a function the "height" (H₁, H₂) of each flux collector (16, 18).

4. A magnetic field sensor as defined in Claim 2 wherein the gap G separating said flux collectors (16, 18) is 1/50 the height of each flux collector, thereby providing a ratio (H₁+H₂+G)/G in a range between more than 50 and 101.

## Patentansprüche

1. Sensor (10) zum Messen gleichförmiger magnetischer Felder, mit einem Substrat (12), einem planaren, magnetoresistiven Element (14) und mit einem ersten und zweiten elektrischen Leiter (20, 22), die auf einer Hauptfläche des Substrats angeordnet bzw. mit einander gegenüberliegenden Enden des magnetoresistiven Elements verbunden sind, um daran einen Meßstrom anzulegen,
**dadurch gekennzeichnet, daß**
das magnetoresistive Element (14) zwischen seinen die einander gegenüberliegenden Enden miteinander verbindenden Seitenkanten eine "Höhen"-Abmessung h hat, und daß
ein erster und ein zweiter laminierter Flußkollektor (16, 18) mit einer "Höhe" H₁ bzw. H₂ auf der Hauptfläche des Substrats angeordnet ist, wobei eine erste Schicht des ersten und zweiten Flußkollektors (16, 18) partiell die Oberfläche des magnetoresistiven Elements (14) in koplanarer Beziehung überlappt, daß der erste Flußkollektor durch einen Spalt G seitlich vom zweiten Flußkollektor beabstandet sind, der kleiner ist als die "Höhe" h des magnetoresistiven Elements, und daß der Magnetfeld-Sensor eine "Höhe" H₁+H₂+G hat, wobei das dimensionslose Verhältnis (H₁+H₂+G)/G größer als 50 ist.

2. Magnetfeld-Sensor nach Anspruch 1, dadurch gekennzeichnet, daß die "Höhen" des ersten und zweiten laminierten Flußkollektors (16, 18) im wesentlichen gleich sind.

3. Magnetfeld-Sensor nach Anspruch 1, dadurch gekennzeichnet, daß die Empfindlichkeit des Magnetfeld-Sensors (10) als Funktion der "Höhe" (H₁, H₂) eines jeden Flußkollektors (16, 18) zunimmt.

4. Magnetfeld-Sensor nach Anspruch 2, dadurch gekennzeichnet, daß der die Flußkollektoren (16, 18) voneinander trennende Spalt G 1/50 der Höhe eines Flußkollektors entspricht, so daß ein Verhältnis (H₁+H₂+G)/G von mehr als 50 bis 101 entsteht.

## Revendications

1. Capteur (10) du type approprié à la mesure de champs magnétiques uniformes, ledit capteur comportant un substrat (12), un élément magnétorésistif plan (14), ainsi que des premier et deuxième conducteurs électriques (20, 22) déposés sur une surface principale dudit substrat et respectivement connectés à des extrémités opposées dudit élément magnétorésistif afin d'appliquer à travers celui-ci un courant de détection, caractérisé en ce que ledit élément magnétorésistif (14) possède une dimension de "hauteur" h entre bords latéraux reliant lesdites extrémités opposées dudit élément magnétorésistif ; en ce que des premier et deuxième collecteurs de flux stratifiés (16, 18) de "hauteurs" respectives H₁ et H₂ sont déposés sur ladite surface principale dudit substrat, une première couche desdits premier et deuxième collecteurs de flux stratifiés (16, 18) chevauchant partiellement la surface dudit élément magnétorésistif (14) suivant une relation coplanaire avec ce dernier, en ce que lesdits premier et deuxième collecteurs de flux stratifiés sont séparés latéralement par un intervalle G qui est inférieur à la "hauteur" h dudit élément magnétorésistif, et en ce que ledit capteur de champ magnétique possède une "hauteur" résultante de H₁+H₂+G, le rapport sans dimension (H₁+H₂+G)/G étant supérieur à 50.

2. Capteur de champ magnétique selon la revendication 1, où les "hauteurs" desdits premier et deuxième collecteurs de flux stratifiés (16, 18) sont sensiblement égales.

3. Capteur de champ magnétique selon la revendication 1, où la sensibilité dudit capteur de flux magnétique (10) augrnente en fonction de la "hauteur" (H₁, H₂) de chaque collecteur de flux (16, 18).

4. Capteur de champ magnétique selon la revendication 2, où l'intervalle G qui sépare les collecteurs de flux (16, 18) est de 1/50 de la hauteur de chaque collecteur de flux, de sorte qu'on obtient un rapport (H₁+H₂+G)/G compris dans l'intervalle de plus de 50 à 101.
